# EUROPÄISCHE PATENTSCHRIFT

(11) **EP 2 142 847 B1**
(45) Veröffentlichungstag und Bekanntmachung des Hinweises auf die Patenterteilung: **11.11.2015**
(21) Anmeldenummer: 07727716.8
(22) Anmeldetag: 03.04.2007
(51) Int. Cl.: F21K 99/00, F21S 8/10, F21V 29/00, F21W 101/10, F21Y 101/02

(54) **HALBLEITERLICHTMODUL**
SEMICONDUCTOR LIGHT MODULE
MODULE D'ÉCLAIRAGE À SEMICONDUCTEURS

(43) Veröffentlichungstag der Anmeldung: 13.01.2010
(73) Patentinhaber: OSRAM GmbH, 80807 München (DE)
(72) Erfinder: BIEBL, Alois, 93358 St. Johann (DE); DIETZ, Stefan, 83642 Otterfing (DE); HIRSCHMANN, Günther, 81735 München (DE)
(86) Internationale Anmeldenummer: PCT/EP2007/053245
(87) Internationale Veröffentlichungsnummer: WO 2008/119392

(56) Entgegenhaltungen:
- WO-A-2004/100624
- WO-A-2005/108853
- WO-A-2006/066530
- COOL POLYMERS:[Online] 31. Dezember 2005 (2005-12-31), XP002459115 Gefunden im Internet: URL:http://www.coolpolymers.com/appsheets/ files/hsthermalmanagementsolutions.pdf> [gefunden am 2007-11-19]

## Beschreibung

### Technisches Gebiet

Die Erfindung betrifft ein Halbleiterlichtmodul gemäß dem Oberbegriff des Anspruchs 1.

### Stand der Technik

Ein derartiges Halbleiterlichtmodul und ein derartiger Fahrzeugscheinwerfer sind beispielsweise in der WO 2006/066530 A1 offenbart. Diese Offenlegungsschrift beschreibt ein Halbleiterlichtmodul mit mindestens einem Leuchtdiodenchip, einem als Kühlkörper ausgebildeten Gehäuse, das den mindestens einen Leuchtdiodenchip teilweise umgibt, und einer Halterung zur Fixierung des mindestens einen Leuchtdiodenchips bezüglich des Kühlkörpers in einer eindeutigen Lage und Ausrichtung, wobei der Kühlkörper mit Befestigungsmitteln zur Montage des Halbleiterlichtmoduls in einem Fahrzeugscheinwerfer versehen ist.

Automobilanwendungen haben gegenüber Anwendungen in der Allgemeinbeleuchtung ein erhöhtes Anforderungsprofil. Es müssen widrige Umwelteinflüsse wie sehr hohe und sehr niedrige Temperaturen, Feuchtigkeit und Spritzwasser überstanden werden, der mechanische Aufbau ist bedingt durch die im Automobil auftretenden Stöße und Vibrationen deutlich robuster auszuführen. Auch an die Elektronik werden besondere Anforderungen gestellt. Dazu zählt ein sehr großer Eingangsspannungsbereich, es sind große Spannungssprünge und Überspannungsspitzen aus dem Bordnetz zu überstehen genauso wie eine sehr strenge Reglementierung gegenüber der elektromagnetischen Verträglichkeit.

Wie aus dem vorgenannten Stand der Technik ersichtlich, werden die Halbleiterlichtquellen in jüngerer Zeit vermehrt direkt auf den Kühlkörper aufgebracht, was eine deutlich erhöhte Wärmeableitung sicherstellt. Die Ansteuerschaltung wird allerdings weiterhin auf einer Platine Platz finden, daher stellt sich das Problem, wie die Ansteuerschaltung und die Halbleiterlichtquellen auf einem Halbleiterlichtmodul Platz finden können. Da moderne Halbleiterlichtquellen wie z.B. LEDs oder OLEDs mit hohen Strömen und oftmals gepulst angesteuert werden, haben Halbleiterlichtmodule oftmals das Problem elektromagnetischer Störungen. Ein Einsatz im Kraftfahrzeug ist immer mit wenig Platzangebot verbunden, und da aus Gründen der Servicefähigkeit ein einfacher Austausch des Moduls ermöglicht werden muss, ist es notwendig, dass die Ansteuerung der Halbleiterlichtquellen und die Halbleiterlichtquellen selbst eine möglichst kompakte Einheit bilden.

Aus WO 2004/100624 A2 ist ein Halbleitermodul mit integrierter Ansteuereletronik bekannt, wobei die Halbleiterlichtquellen auf einer ersten Ebene und die Ansteuerelektronik auf einer zweiten Ebene einer Platine angeordnet sind.

### Aufgabe

Es ist daher Aufgabe der Erfindung, ein Halbleiterlichtmodul anzugeben, bei dem die Elektromagnetische Verträglichkeit gegenüber dem vorgenannten Stand der Technik verbessert ist.

### Darstellung der Erfindung

Diese Aufgabe wird durch die Merkmale des Patentanspruchs 1 gelöst. Besonders vorteilhafte Ausführungen der Erfindung sind in den abhängigen Ansprüchen beschrieben.

Das erfindungsgemäße Halbleiterlichtmodul besteht aus einem scheibenförmigen Modul mit guter thermischer Leitfähigkeit, auf dem in etwa in der Mitte eine oder mehrere Halbleiterlichtquellen angeordnet sind. Dieser Bereich ist gegenüber dem umgebenden Bereich erhaben. Entlang des Umfangs des Moduls befindet sich eine Seitenwand, die in etwa die gleiche Höhe hat wie der erhabene Bereich, auf dem sich die Halbleiterlichtquellen befinden. Dadurch entsteht ein in Lichtabstrahlrichtung offener Innenraum. An dem erhabenen Bereich und an der Seitenwand ist ein tiefer liegender Absatz vorhanden. Das Modul ist zumindest an der Oberfläche leitfähig und elektrisch mit der Masse der Ansteuerschaltung verbunden. Die Ansteuerschaltung befindet sich auf einer Runden Platine, die einen geringfügig kleineren Durchmesser wie das Modul hat und in der Mitte, im Bereich der Halbleiterlichtquellen ausgespart ist. Diese Platine ist am Modul befestigbar und liegt in der Mitte wie am Rand auf dem Absatz auf. Der Innenraum im Modul ist damit durch die Platine geschlossen und das Modul und die Platine bilden eine Kavität aus. Die Platine wird elektrisch leitend mit dem Modul verbunden, und die Halbleiterlichtquellen werden an die Ansteuerschaltung auf der Platine angeschlossen.

Durch diesen mechanischen Aufbau ergibt sich ein kompaktes Halbleiterlichtmodul, das eine gute Wärmeableitung für die Halbleiterlichtquellen gewährleistet. Die Ansteuerschaltung ist auf dem Modul integriert und die Leitungen zwischen der Ansteuerschaltung und den Halbleiterlichtquellen können sehr kurz gehalten werden. Durch die Kavität im Modul kann die Platine auf beiden Seiten mit elektronischen Bauelementen bestückt werden. Die erste Leiterbahnebene zeigt nach außen hin in Lichtabstrahlrichtung, die zweite Leiterbahnebene zeigt nach innen und ist vollständig von der Kavität umschlossen.

Alle elektromagnetische Störungen verursachenden Schaltkreise befinden sich dabei bevorzugt auf der zweiten Leiterbahnebene.

An das thermisch leitfähige Modul kann einstückig ein Kühlkörper angebracht sein, wobei der Kühlkörper rippenförmige Strukturen, aber auch vereinzelte Kühlelemente aufweisen kann. Die vereinzelten Kühlelemente können verschiedene Formen, z.B. waben- oder tropfenförmige Formen haben. Im Prinzip sind alle möglichen Formen, vor allem aber achsensymmetrische Formen denkbar.

Soll das Halbleiterlichtmodul für die Allgemeinbeleuchtung als Downlight eingesetzt werden, so kann der Kühlkörper Rohrförmig mit einer z.B. wabenförmigen Innenstruktur ausgebildet sein. Dadurch lässt sich ein Kamineffekt erzielen, der einen kontinuierlichen Luftstrom durch den Kühlkörper erzeugt. Dazu ist eine Lufteinlassöffnung an der lichtabgewandten Seite der Modulscheibe notwendig.

Eine weitere Ausführungsform sieht vor, dass der Kühlkörper nicht Teil der Modulscheibe, sondern an ihr anbringbar ist.

Die Halbleiterlichtquellen können LEDs oder auch OLEDs sein.

Um die elektromagnetischen Störungen abzuschirmen, die die Schaltung auf der zweiten Leiterbahnebene erzeugt, ist es zweckmäßig, dass die Platine eine Mittellage besitzt, die elektrisch mit der Modulscheibe verbunden ist, und sich damit auf Massepotential befindet.

### Kurze Beschreibung der Zeichnung(en)

- Fig. 1: Dreidimensionale Explosionsansicht des erfindungsgemäßen Halbleiterlichtmoduls in einer ersten Ausführungsform.
- Fig. 2: Isometrische Ansicht einer zweiten Ausführungsform des erfindungsgemäßen Halbleiterlichtmoduls.
- Fig. 3a: Draufsicht einer ersten Ausführungsform des erfindungsgemäßen Halbleiterlichtmoduls.
- Fig. 3b: Schrägansicht einer zweiten Ausführungsform des erfindungsgemäßen Halbleiterlichtmoduls.
- Fig. 4: Isometrische Ansicht einer ersten Variante der zweiten Ausführungsform des erfindungsgemäßen Halbleiterlichtmoduls.
- Fig. 5a, 5b: Isometrische Ansicht einer zweiten Variante der zweiten Ausführungsform des erfindungsgemäßen Halbleiterlichtmoduls.
- Fig. 6a, 6b: Isometrische Ansicht einer dritten Variante der zweiten Ausführungsform des erfindungsgemäßen Halbleiterlichtmoduls.
- Fig. 7a, 7b: Isometrische Ansicht einer vierten Variante der zweiten Ausführungsform des erfindungsgemäßen Halbleiterlichtmoduls.
- Fig. 8: Blockschaltbild der auf der Platine angeordneten Ansteuerlogik.
- Fig. 9a, 9b: Isometrische Ansicht der Platine mit der ersten und der zweiten Leiterbahnebene. Bevorzugte Ausführung der Erfindung

### Erste Ausführungsform

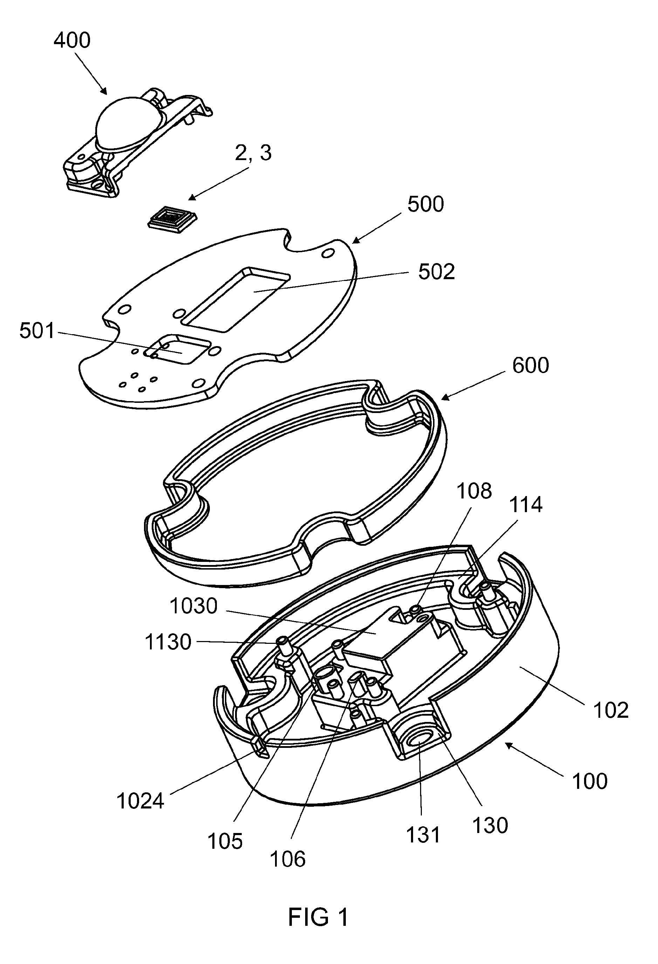

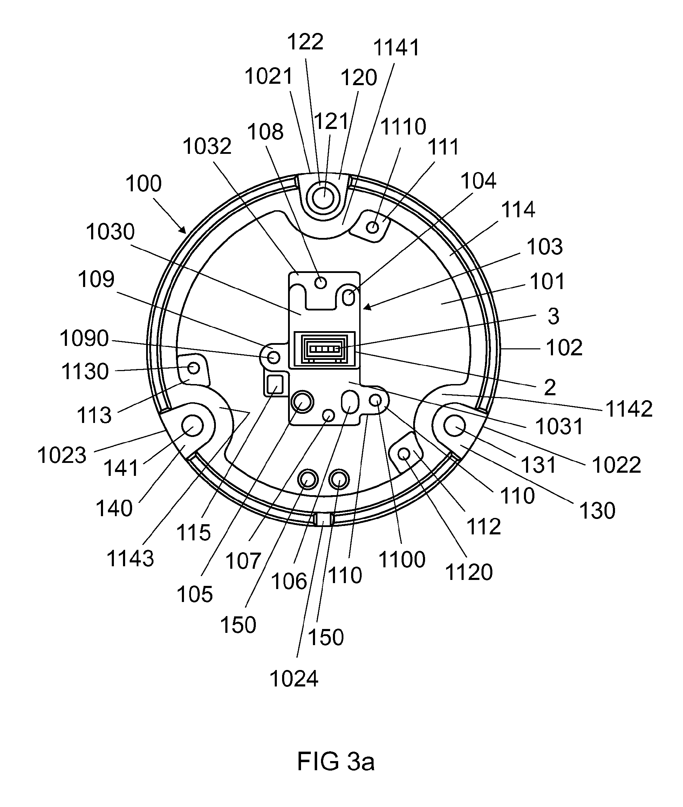

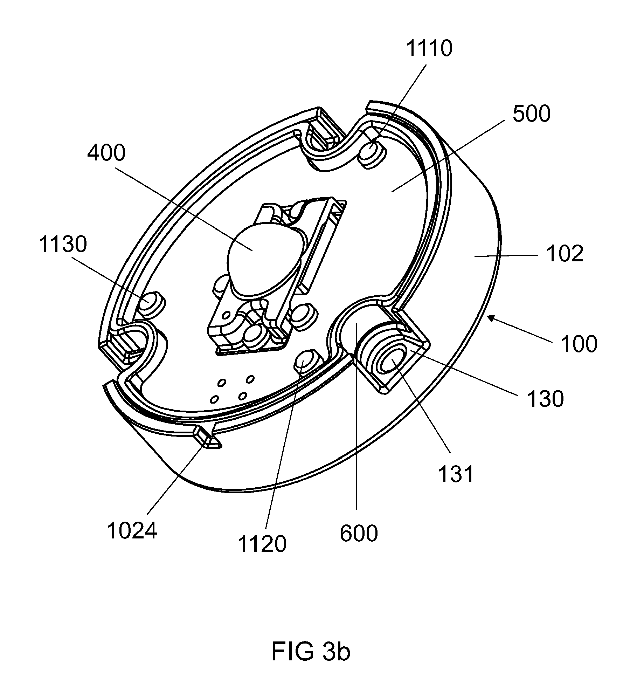

Die erste Ausführungsform ist in den Figuren 1, 3a und 3b gezeigt. Sie umfasst ein scheibenförmiges Halbleiterlichtmodul, an dem ein Kühlkörper befestigt werden kann.

Das Halbleiterlichtmodul gemäß der ersten Ausführungsform der Erfindung umfasst ein topfartiges, im wesentlichen zylindersymmetrisches Gehäuse 100 aus Aluminium mit einem kreisscheibenartigen Boden 101 und einer, am Boden 101 angeformten Seitenwand 102, die entlang der Mantelfläche eines Zylinders verläuft. Der Boden 101 und die Seitenwand 102 bilden einen Innenraum. Das Gehäuse 100 ist insbesondere als Aluminiumdruckgussteil ausgebildet. Der Boden 101 des Gehäuses 100 weist an seiner Innenseite eine einteilig mit dem Boden 101 ausgebildete Erhebung 103 auf, die einen hohen Mittelabschnitt 1030 und zwei tiefer liegende Plateaus 1031, 1032 besitzt. Die Oberseite des Mittelabschnitts 1030 besitzt eine größere Höhe über dem Boden 101 des Gehäuses 100 als die beiden, auf unterschiedlichen Seiten des Mittelabschnitts angeordneten Plateaus 1031, 1032. Die Oberseite des Mittelabschnitts bildet eine Auflagefläche für eine Trägerplatte 2 aus Keramik, die als Träger für fünf Leuchtdiodenchips 3 dient, und für eine Primäroptik. Die Trägerplatte 2 gewährleistet eine elektrische Isolierung zwischen dem metallischen Gehäuse 100, insbesondere der Erhebung 103, und den Leuchtdiodenchips 3. Die fünf Leuchtdiodenchips 3 sind auf der Trägerplatte 2 in einer Reihe angeordnet und von den Wänden eines Rahmens umgeben. Es können aber auch sechs Leuchtdiodenchips in zwei Reihen angeordnet sein. Die Leuchtdiodenchips 3 emittieren blaues Licht und sind mit einer Leuchtstoffbeschichtung (Chip-Layer-Coating) versehen, um die Wellenlänge eines Teils der von den Leuchtdiodenchips 3 generierten elektromagnetischen Strahlung zu konvertieren, so dass die Beleuchtungseinrichtung während ihres Betriebs weiß erscheinendes Licht emittiert. Bei den Leuchtdiodenchips 3 handelt es sich beispielsweise um Dünnfilm-Leuchtdiodenchips, deren Grundprinzip beispielsweise in der Druckschrift I. Schnitzer et al., Appl. Phys. Lett. 63 (16), 18. Oktober 1993, 2174-2176 beschrieben ist. Die Trägerplatte 2 wird mittels eines Bestückungsautomaten auf der Oberseite des Mittelabschnitts 1030 der Erhebung 103 in einem vorgegebenen Abstand und in wohl definierter Orientierung bezüglich eines auf dem ersten Plateaus 1031 angeordneten, hohlzylindrischen Stegs 105 und eines auf dem zweiten Plateau 1032 angeordneten Langlochs 104 aufgeklebt. Die Trägerplatte 2 mit den darauf angeordneten Leuchtdiodenchips 3 ist zwischen dem Langloch 104 und dem hohlzylindrischen Steg 105 angeordnet. Die Oberseite des zylindrischen Hohlstegs 105 und des Stegs 106 mit ovalem Quersteg besitzen dieselbe Höhe über dem Gehäuseboden 101 wie die Oberseite des Mittelabschnitts 1030.

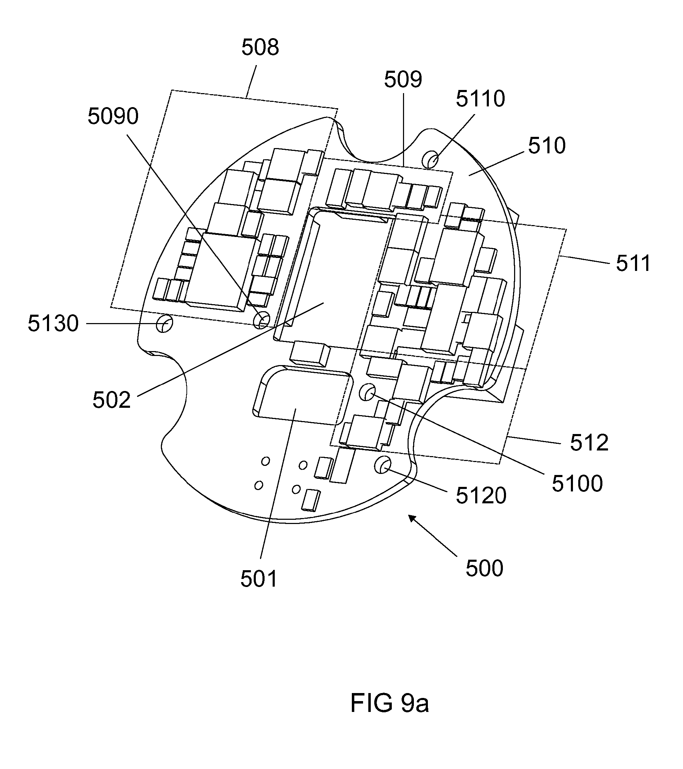

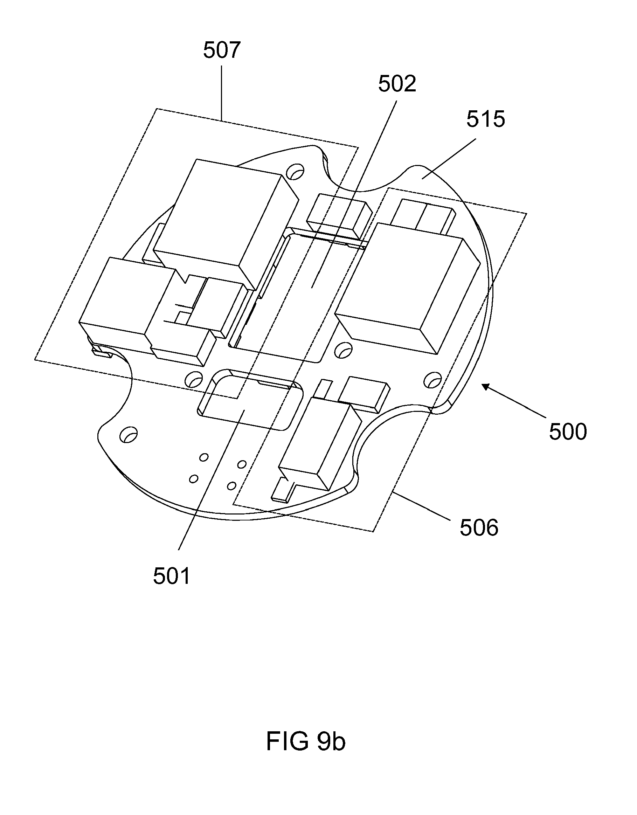

Im Bereich des ersten Plateaus 1031 weist die Erhebung 103 zwei auf unterschiedlichen Seiten des Plateaus 1031 angeordnete, ohrenartige Anformungen 109, 110 mit jeweils einem Stift 1090, 1100 auf. Die Stifte 1090, 1100 dienen zur Vernietung einer Montageplatine 500, die auf der Oberseite des ersten 1031 und des zweiten Plateaus 1032 sowie auf drei weiteren, mit jeweils einem Stift 1110, 1120, 1130 versehenen Auflageflächen 111, 112, 113 aufliegt. Die vorgenannten Auflageflächen 111, 112, 113 sind äquidistant entlang der Innenseite eines an der Innenseite der Seitenwand 102 verlaufenden ringförmigen Stegs 114 angeordnet. Die Montageplatine 500 (Figur 9a, 9b) besitzt zwei im Wesentlichen rechteckige Durchbrüche 501, 502, durch die der Mittelabschnitt 1030 und die Stege 105, 106 sowie die Stifte 107, 108 hindurch ragen. Auf der Montageplatine sind die Komponenten eines Betriebsgerätes für die Leuchtdiodenchips 3 montiert. Insbesondere umfasst das Betriebsgerät eine interne Spannungsversorgung 509, eine Fehlererkennungslogik 512, eine Deratinglogik 508, und eine Ansteuerlogik für einen Gleichspannungswandler 511 die auf einer ersten Leiterbahnebene 510 liegen, sowie einen Eingangsfilter (506) und den Gleichspannungswandler (507) zur Energieversorgung der LEDs aus der Bordnetzspannung des Kraftfahrzeugs, die auf der zweiten Leiterbahnebene 515 liegen. Ein temperaturabhängiger Widerstand 525, insbesondere ein so genannter NTC (Widerstand mit negativer Temperaturcharakteristik), ist an die Deratinglogik 508 angeschlossen. Diese Logik sorgt dafür, dass die Leuchtdiodenchips 3 bei zu hoher Temperatur mit verminderter Leistung angesteuert werden. Die Fehlererkennung 512 signalisiert den Ausfall einer LED bzw. eines LED Strangs über einen Statusausgang 540 (Pin, z.B. Ausführung mittels Open Kollektor). Eine Anzeige am Kfz-Armaturenbrett ist somit möglich. Der Eingangsfilter 506 sorgt dafür, dass keine leitungsgebundenen Störungen über die stromführenden Zuleitungen nach aussen gelangen können. Die großen, leistungsführenden Bauelemente, die durch ihren getakteten Betrieb starke elektromagnetische Störungen Verursachen, liegen somit alle auf der zweiten Leiterbahnebene 515, die im eingebauten Zustand der Platine 500 nach innen in den Innenraum zeigt. Auf der ersten Leiterbahnebene 510, die in Lichtabstrahlrichtung zeigt, befinden sich somit lediglich Logikbaugruppen, die mit Kleinsignalspannungen aus der internen Spannungsversorgung 509 betrieben werden. Die Platine 500 wird über 5 Befestigungspunkte 1090, 1100, 1110, 1120, 1130 mit dem Gehäuse 100 verbunden. Die Befestigung kann durch Schrauben, Nieten, Löten, Schweißen, Heißverstemmen, usw. erfolgen. Bevorzugt wird die Platine auf das Gehäuse aufgenietet. Diese Befestigung stellt eine gute elektrische Leitfähigkeit der Anschlussbohrungen 5090, 5100, 5110, 5120, 5130 zum Gehäuse 100 her. Die Anschlussbohrungen sind vorzugsweise mit einer dritten Leiterbahnebene, die nur das Massepotential führt, verbunden. Die dritte Leiterbahnebene ist in der Platine innenliegend zwischen der ersten und der zweiten Leiterbahnebene angeordnet. Die dritte Leiterbahnebene schirmt alle Störungen, die durch die leistungsführenden Bauteile auf der zweiten Leiterbahnebene 515 entstehen ab. Die leitungsgebundenen Störungen werden durch den Eingangsfilter in π-Topologie (506) ausgefiltert. Dabei ist vor allem entscheidend, dass der Eingangsfilter der LED Ansteuerschaltung eine sehr gute Ankopplung an die Masseleiterbahnebene der Ansteuerschaltung besitzt. Diese Ankopplung kann DC- oder AC mäßig erfolgen. Ist ein direkter DC-Anschluss aus schaltungstechnischen Gründen nicht möglich, wird dieser AC-mäßig hergestellt. AC mäßig bedeutet über einen Koppelkondensator C_{Koppel}. Der Rand der nahezu kreisscheibenförmigen Montageplatine 500 schließt mit der Innenseite der ringförmigen Auflagefläche 114 für den Dichtring 600 ab, so dass die Montageplatine 500 mit der masseführenden Leiterbahnebene und der Gehäuseboden 101 sowie der ringförmige Steg 114 bzw. der darauf liegende Dichtungsring 600 eine Kavität bilden, die alle störenden Bauteile umschließt und die Störungen nach außen abschirmt. Das Halbleiterlichtmodul zeigt somit ein optimales EMV-Verhalten.

Um außer dem optimalen EMV-Verhalten auch einen optimalen Betrieb der Leuchtdiodenchips 3 sicherzustellen, sollte die Ansteuerschaltung weitere Merkmale aufweisen. Für eine optimale Ansteuerung der Leuchtdiodenchips 3 ist eine Konstantstromregelung notwendig. Bedingt durch das nicht stabile Kfz-Bordnetz ist eine Boost-Buck Wandlertopologie (gleichzeitiger Hoch- und Tiefsetzsteller eines Gleichspannungswandlers) zu empfehlen. Um die Wärmeerzeugung des Halbleiterlichtmoduls im Rahmen zu halten ist ein guter Wirkungsgrad der Ansteuerschaltung von über 80% notwendig. Die Merkmale der Fehlerdiagnoseschaltung und der Deratinglogik wurden schon vorab diskutiert, daher werden sie hier nicht mehr wiederholt. Um die Lichtabgabe des Scheinwerfers über die Lebensdauer gleich zu halten, kann eine Helligkeitseinstellung (Justierung des Lichtstromes der LEDs in einem vorgegebenen Fenster) implementiert werden. Für andere Anwendungen, z.B. für ein kombiniertes Rück/- Bremslicht oder für eine dimmbare Leuchte in der Allgemeinbeleuchtung kann ein Eingang 530 zum Dimmen mittels PWM (Pulsweitenmodulation) vorgesehen sein. Um Schäden durch unsachgemäße Handhabung, z.B. durch falsch gepolten Anschluss des Halbleiterlichtmoduls auszuschließen kann eine Verpolschutzdiode vorgesehen sein. Wird das Halbleiterlichtmodul für KfZ-Anwendungen konzipiert, ist normalerweise ein Überspannungsschutz (Treten im Kfz-Bordnetz kurzfristig höhere Spannungen auf, als die übliche Bordspannung, bedingt durch Schalten von, speziell induktiven, Lasten, wird die Ansteuerschaltung nicht zerstört.) notwendig. Auch eine Kurzschlussfestigkeit des Ausgangs für die Leuchtdiodenchips 3 kann vorgesehen sein.

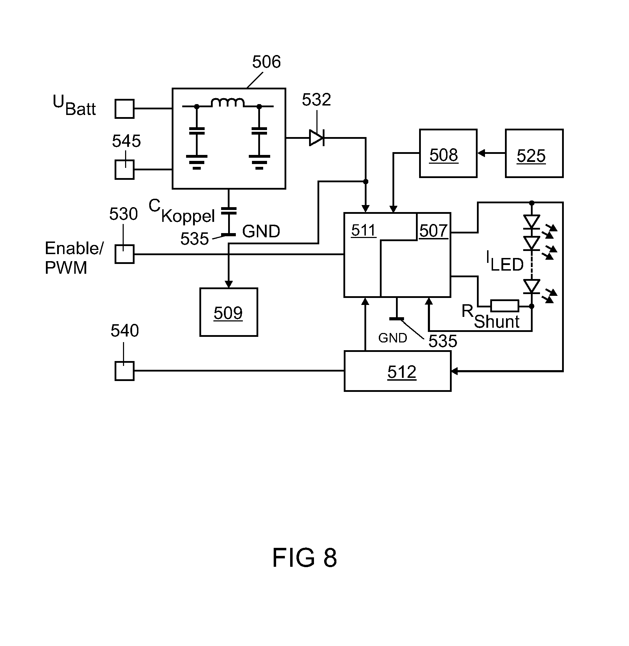

Aus den vorher erwähnten Merkmalen, die eine LED Ansteuerschaltung für ein Halbleiterlichtmodul im Kraftfahrzeug (Kfz) haben sollte, lässt sich eine Schaltung entwickeln, die folgendes, in Figur 8 dargestelltes Blockschaltbild aufweist. Damit die Ansteuerschaltung für die LEDs einen hohen Wirkungsgrad besitzt, ist der Einsatz eines Gleichspannungswandlers 507 notwendig. Kernstück des LED Treibers ist deshalb ein Gleichspannungswandler 507, der je nach Anzahl der angeschlossenen Leuchtdioden 3 Hoch- oder Tiefsetzstellereigenschaften, oder eine Kombination aus Beiden, aufweist. Da ein Gleichspannungswandler 507 mit einer bestimmten Frequenz arbeitet, ist es aus EMV-technischen Gründen erforderlich einen Eingangsfilter (z.B. n-Filter) vor dem eigentlichen Gleichspannungswandler 507 zu platzieren. Um die Wirkungsweise des Filters nicht zu beeinträchtigen, sollte dieser einen direkten oder zumindest einen indirekten (wechselstrommäßigen) Anschluss an die Systemmasse (535) des Gleichspannungswandlers aufweisen und somit auch an das kühlende Element (hier: Gehäuse 100 mit oder ohne Kühlkörper). Der wechselstrommäßige Anschluss des Filters kann mittels eines Koppelkondensators C_{Koppel} realisiert werden. Da die Eingangsfiltermasse 545 aus schaltungstechnischen Gründen eine andere Bezugsmasse als die restliche LED Ansteuerschaltung (Systemmasse 535) haben kann, ist die oben beschriebene Maßnahme durchzuführen. Dem Eingangsfilter 506 nachgeschaltet ist eine Verpolschutzdiode, die die LED Ansteuerschaltung vor Verpolung schützen soll. Neben dem in Figur 8 gezeigten passiven Verpolschutz mittels Diode, zweckmäßig ist natürlich eine Schottky-Diode, ist ebenfalls ein aktiver Verpolschutz mittels MOSFET möglich. Eine Deratingschaltung 508, an der ein Temperaturfühler 525 (z.B. NTC Widerstand) angeschlossen ist, sorgt für eine temperaturabhängige Stromregelung, zum Schutz der LED vor thermischer Zerstörung. Der Temperaturfühler 525 überwacht durch thermische Ankopplung an die LEDs (bzw. den LED Strang oder das LED Array) deren Temperatur. Eine Überschreitung des Durchlassstromes I_{LED} der LED in den verbotenen Bereich (lt. Datenblatt der verwendeten LEDs) führt unverzüglich zu einer Verminderung desselben. Neben der Temperaturüberwachungsschaltung 508 (Derating) ist noch eine Fehlererkennungsschaltung 512 implementiert. Herrscht am LED Treiberausgang eine Unterbrechung im LED Strang, der mindestens aus einer LED besteht, oder ist keine LED angeschlossen, wird dies am Fehlererkennungsausgang 540 signalisiert. Zweckmäßig ist dieser Ausgang als Open Kollektor ausgeführt. Damit ist die Möglichkeit gegeben verschiedene Logiken (die über z.B. Pullup Widerstände angeschlossen sind) mit unterschiedlichen Spannungen zur Weiterverarbeitung des Fehlersignals anzuschließen.

Neben der ohrenartigen Anformung 109 und dem hohlzylindrischen Steg 105 ist in der Erhebung 103 ein Trog 115 ausgebildet, der mit einer Wärme leitenden Paste gefüllt ist. Auf dem Trog 115 ist der temperaturabhängige Widerstand (525) angeordnet, der mit der Wärme leitenden Paste in Kontakt steht und als Temperatursensor dient, um die Betriebstemperatur der Leuchtdiodenchips 3 zu messen. Die Seitenwand 102 weist drei entlang des Umfangs des Gehäuses 100 angeordnete Aussparungen 1021, 1022, 1023 auf, in denen jeweils eine parallel zum Gehäuseboden 101 verlaufende Fläche 120, 130, 140 angeordnet ist. Diese Flächen 120, 130, 140 befinden sich auf gleicher Höhe über dem Gehäuseboden 101 und werden jeweils durch eine in das Innere des Gehäuses 100 gerichtete Einbuchtung 1141, 1142, 1143 des ringförmigen Stegs 114 begrenzt. In der ersten Fläche 120 ist eine durchgängige, in Richtung des Gehäusebodens 101 stufenartig verengte Bohrung 121 angeordnet, die von der Fläche 120 bis zur Außenseite des Gehäusebodens 101 reicht. Die Bohrung 121 ist derart ausgebildet, dass in der Fläche 120 eine kreiszylindrische Vertiefung 122 angeordnet ist, deren Außenradius dem ersten, großen Radius der Bohrung 121 und deren Innenradius dem zweiten, kleinen Radius der Bohrung entspricht. Die Tiefe der Bohrung 121 beträgt im Bereich des ersten, großen Radius nur wenige Millimeter, während der Bereich der Bohrung 121 im Bereich des zweiten, kleinen Radius von dem Boden der Vertiefung 122 bis zur Außenseite des Gehäusebodens 101 reicht. Das heißt, die Höhe des Bodens der Vertiefung 122 über dem Gehäuseboden 101 ist nur um wenige Millimeter geringer als die Höhe der Flächen 120, 130, 140 über dem Gehäuseboden 101. In den anderen beiden Flächen 130, 140 ist ebenfalls jeweils eine durchgängige Bohrung 131, 141 angeordnet, deren Radius jeweils mit dem Radius des engen Bereichs der ersten Bohrung 121 übereinstimmt. In dem Gehäuseboden 101 sind ferner zwei Durchbrüche 150 angeordnet, die zur Durchführung von elektrischen Anschlusskabeln für die Energieversorgung der auf der Montageplatine montierten Komponenten des Betriebsgeräts dienen. Außerdem weist der Gehäuseboden 101 vorzugsweise drei weitere Bohrungen zur Befestigung eines Kühlkörpers (nicht abgebildet) auf. Ebenfalls ist neben der reinen Kabelversion auch eine Variante mit Stecker wie in der zweiten Ausführungsform verfügbar.

### Zweite Ausführungsform

Die zweite Ausführungsform unterscheidet sich durch die erste Ausführungsform dadurch, dass ein Kühlkörper einstückig an das Halbleiterlichtmodul angeformt ist. Da die Bauweise ansonsten die gleiche ist wie in der ersten Ausführungsform, werden hier nur die Unterschiede zur ersten Ausführungsform beschrieben.

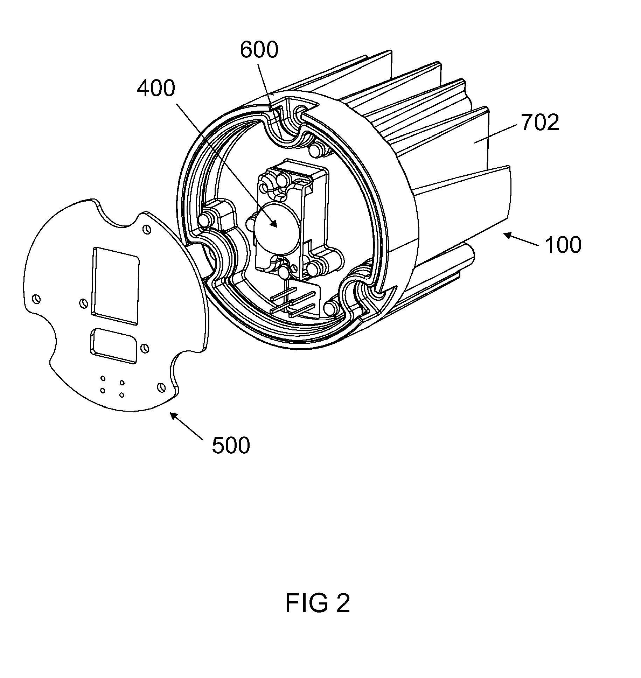

Die zweite Ausführungsform ist in den Figuren 2, 4, 5a, 5b, 6a, 6b, 7a und 7b in verschiedenen Varianten gezeigt. Diese Ausführungsform besitzt einen einstückig an das Halbleiterlichtmodul angeformten Kühlkörper. Dies hat den Vorteil einer besseren Wärmeableitung sowie einer einfacheren und damit kostengünstigeren Montage des gesamten Halbleiterlichtmoduls. Anstatt der beiden Durchbrüche 150 für die Anschlusskabel ist ein Durchbruch für eine Steckerbuchse vorhanden. Es kann aber auch eine Kabelversion, wie in der ersten Ausführungsform beschrieben, vorgesehen sein. Für die Ausführung des Kühlkörpers sind verschiedene Varianten denkbar.

Die Leistung eines Kühlkörpers hängt wesentlich davon ab, welche Bedingungen in dem Volumen, in dem der Kühlkörper sich befindet, herrschen. Ist eine Zwangslüftung vorhanden, kann der Kühlkörper anders ausgeformt werden als wenn nur eine natürliche Konvektion genutzt werden kann. In den meisten Leuchten, vor allem in Fahrzeugscheinwerfern kann lediglich eine natürliche Konvektion genutzt werden. Ein Fahrzeugscheinwerfer strahlt sein Licht annähernd horizontal über dem Boden ab, daher ist das Halbleiterlichtmodul auch in etwa horizontaler Ausrichtung im Scheinwerfer eingebaut.

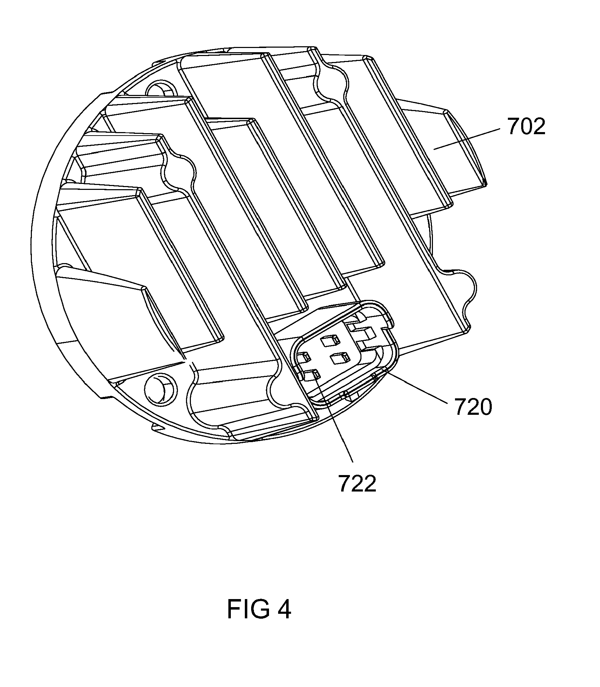

In der ersten Variante der zweiten Ausführungsform hat der Kühlkörper eine rippenförmige Struktur. Da sich die Luft am Kühlkörper aufheizt, wird eine natürliche Konvektion von unten nach oben stattfinden. Daher muss bei dieser Methode die Einbaulage des Moduls bekannt sein, um bei seinem Einbauort die Kühlrippen in die Luftströmung auszurichten, um somit noch einen maximalen Kühleffekt zu erzielen. D.h. hier muss der Anwender auf die Lage des Einbauortes Rücksicht nehmen. Des weiteren kann es vorkommen, dass Luft, die im Inneren des durch die Rippen 702 gebildeten Kanals strömt, nicht mit der Kühlkörperwand in Kontakt kommt und somit keine Wärme von dieser abführen kann. Dies reduziert die maximal mögliche Kühlwirkung. Wie in Fig. 4 ersichtlich, wird die Kühlluft ansonsten lediglich durch die auf der Lichtabgewandten Seite angeformte Steckerbuchse 720 mit den Kontakten 722 in ihrem Fluss gestört.

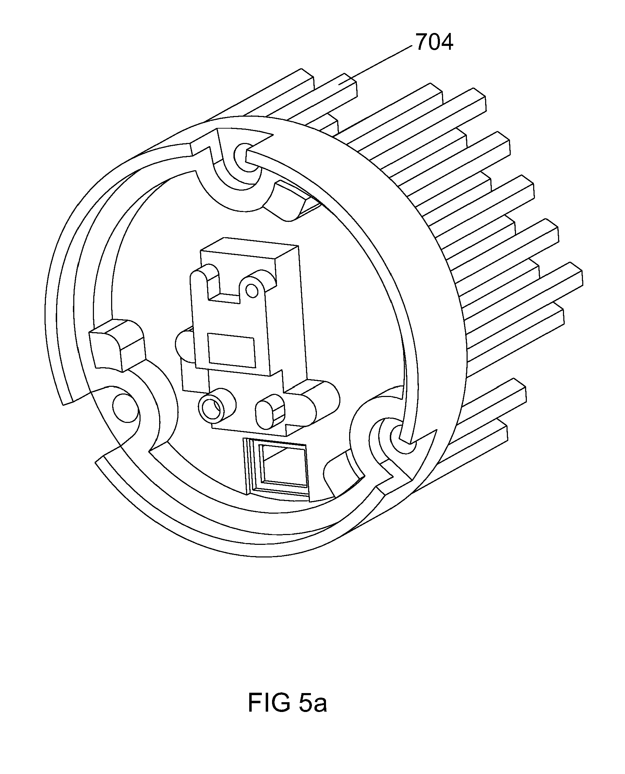

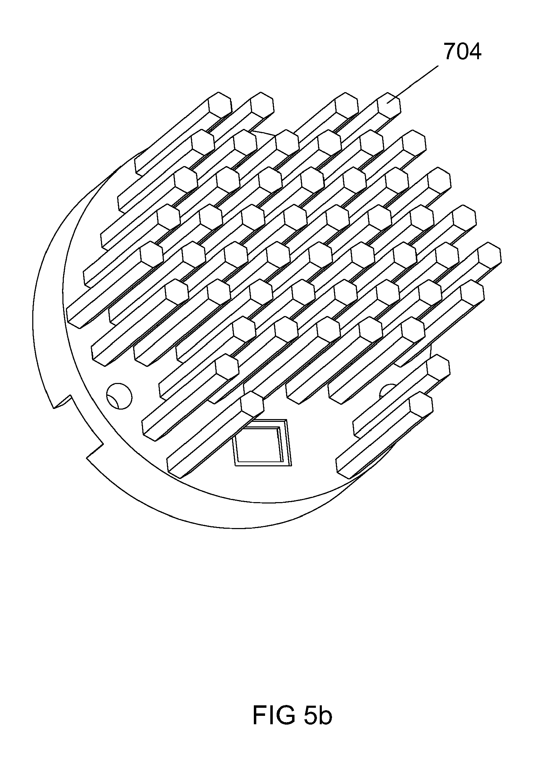

Die erste Variante der zweiten Ausführungsform ist ein Kühlkörper mit vereinzelten Kühlelementen, z.B. wabenartigen Domen 704, wie in Figur 5 a und b gezeigt. Bei diesem Kühlkörperkonzept kann die Luft in allen Richtungen den Kühlkörper durchströmen, die Einbaulage muss sich daher nicht mehr nach der Luftströmung richten. Ein zusätzlicher Kühleffekt wird dadurch erzielt, dass die Kühlelemente "auf Lücke" gesetzt werden und so die Luft nicht ungehindert durch die Wabendome strömen kann, wie bei einer Rippenform des Kühlkörpers. Durch eine Zwangsverwirbelung wird eine Strömungskanalbildung unterbunden und es wird die gesamte Luft zur Wärmeabfuhr genutzt.

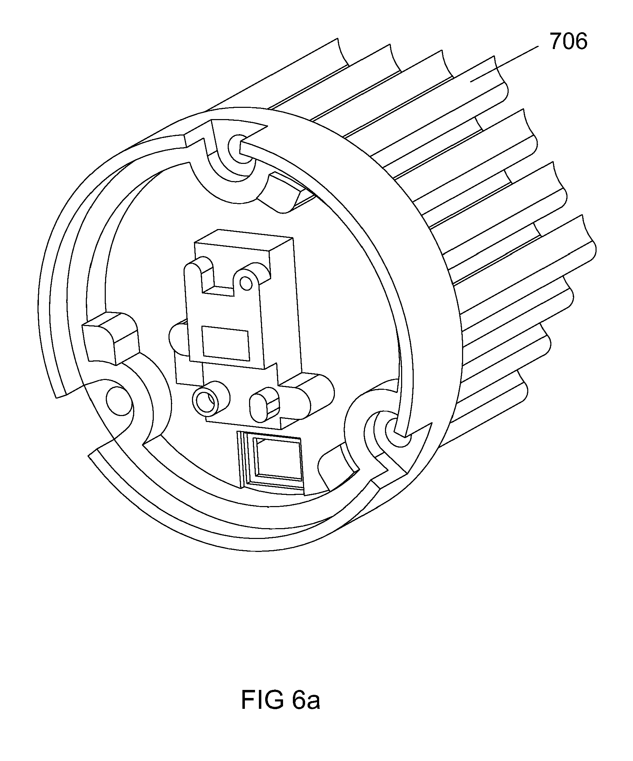

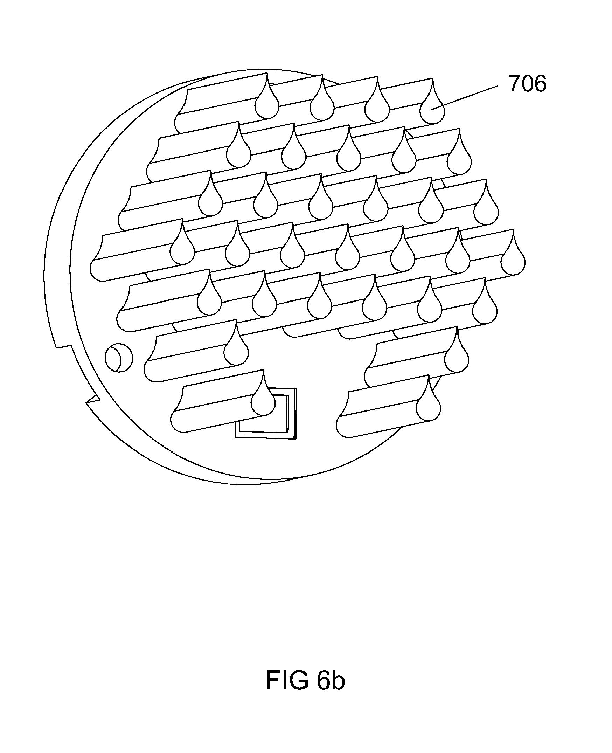

Durch Verwirbelungen der Luftströmungen auf der strömungsabgewandten Seite eines Kühlelementes wird die Strömungsgeschwindigkeit und dadurch die Wärmeabgabe durch Konvektion herabgesetzt. Dieser Nachteil kann vermieden werden, indem eine aerodynamisch verbesserte Form der Kühlelemente gewählt wird, so z.B. eine verbesserte Tropfenform 706 der dritten Variante, wie in Figur 6 a und b angegeben. Der Effekt der Strömungskanalbildung kann auch hier durch versetztes Platzieren der Kühlelemente 706 erzeugt werden. Bei dieser Form muss jedoch wiederum auf die Einbaulage geachtet werden, da die aerodynamische Form nur bei einer bekannten Luftströmungsrichtung, z.B. durch einen Ventilator oder durch natürliche Konvektion von unten nach oben, ihre Vorteile ausspielen kann.

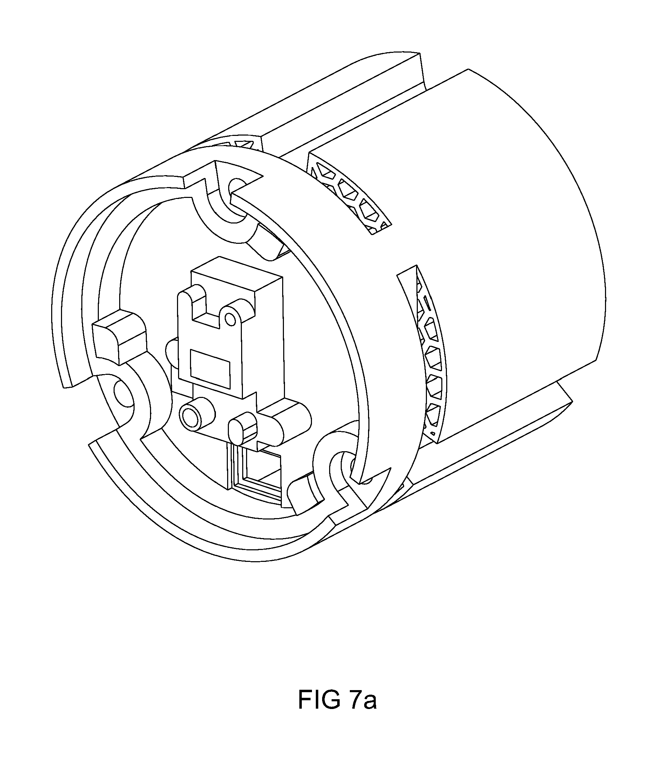

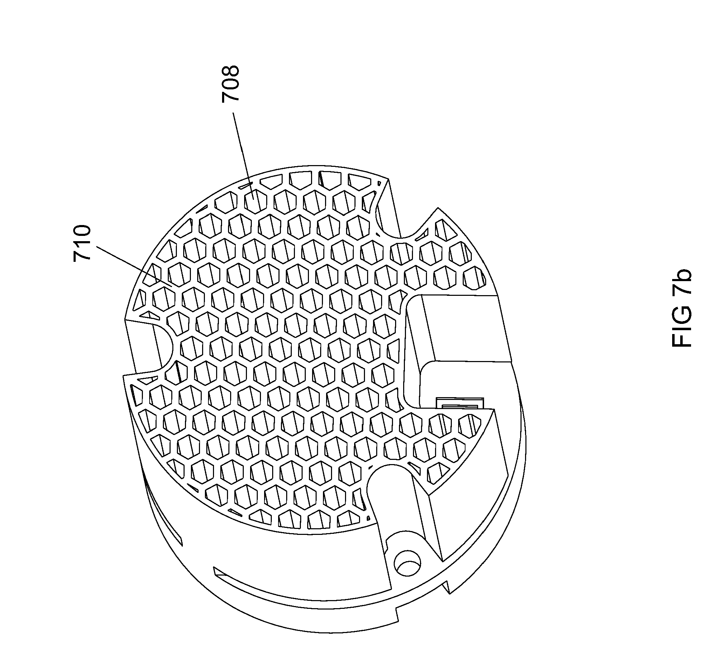

Befindet sich die Wärmequelle unterhalb des Kühlkörpers kann durch eine symmetrische Röhrenstruktur eine gleichförmige Strömung und somit ein Kamineffekt erzeugt werden. Die vierte Variante der zweiten Ausführungsform besitzt eine wabenartige Struktur mit Stegen 710 und wabenförmigen Öffnungen 708 (Figur 7a und b). Diese Form der Kühlung setzt jedoch voraus, dass sich die Leuchtdiodenchips 3 am unteren Ende der Leuchte befinden und daher nahezu senkrecht nach unten abstrahlen. Diese Anwendung ist im Automobileinsatz eher selten, spielt aber z.B. bei der Allgemeinbeleuchtung eine Rolle. Eine mögliche Anwendung wären Downlights, bei denen der Kamineffekt über solch einen wabenförmigen Kühlkörper ausgenutzt werden kann.

## Patentansprüche

1. Halbleiterlichtmodul mit integrierter Ansteuerelektronik, wobei das Halbleiterlichtmodul aus einem Wärme leitenden, elektrisch leitenden Material besteht, auf dem sich eine Platine (500) befindet, wobei die Platine (500) aus mindestens 2 Leiterbahnebenen besteht, die erste Ebene (510) im Einbauzustand nach außen hin in Lichtabstrahlrichtung zeigt und die zweite Ebene (515) nach innen,
**dadurch gekennzeichnet, dass** mindestens eine Halbleiterlichtquelle auf das scheibenförmige Halbleiterlichtmodul aufgebracht ist, und die Platine mit der Ansteuerelektronik um die Halbleiterlichtquelle herum platziert ist, wobei die zweite Ebene (515) von einer in das Halbleiterlichtmodul eingearbeiteten geschlossenen Kavität umhüllt wird, und wobei die masseführenden Leitungen der Platine (500) mit der Oberfläche des Halbleiterlichtmoduls elektrisch verbunden sind.

2. Halbleiterlichtmodul nach Anspruch 1, **dadurch gekennzeichnet, dass** die elektromagnetische Störungen verursachenden Schaltkreise sich vorwiegend auf der zweiten Leiterbahnebene befinden.

3. Halbleiterlichtmodul nach einem der Ansprüche 1 oder 2, **dadurch gekennzeichnet, dass** das Halbleiterlichtmodul einen einstückig angeformten Kühlkörper besitzt.

4. Halbleiterlichtmodul nach Anspruch 3, **dadurch gekennzeichnet, dass** der Kühlkörper mit Kühlrippen versehen ist.

5. Halbleiterlichtmodul nach Anspruch 3, **dadurch gekennzeichnet, dass** der Kühlkörper mit vereinzelten Kühlelementen versehen ist.

6. Halbleiterlichtmodul nach Anspruch 5, **dadurch gekennzeichnet, dass** die vereinzelten Kühlelemente eine achsensymmetrische Form aufweisen.

7. Halbleiterlichtmodul nach Anspruch 5, **dadurch gekennzeichnet, dass** die vereinzelten Kühlelemente eine Waben- oder Tropfenform aufweisen.

8. Halbleiterlichtmodul nach Anspruch 3, **dadurch gekennzeichnet, dass** der Kühlkörper eine Röhrenstruktur aufweist und dass sich am unteren Rand des Kühlkörpers eine Lufteintrittsöffnung befindet, so dass eine Luftzirkulation durch den auftretenden Kamineffekt begünstigt wird.

9. Halbleiterlichtmodul nach einem der Ansprüche 1 oder 2, **dadurch gekennzeichnet, dass** ein externer Kühlkörper an das Halbleiterlichtmodul anbringbar ist.

10. Halbleiterlichtmodul nach einem der vorhergehenden Ansprüche, **dadurch gekennzeichnet, dass** die Halbleiterlichtquelle aus mindestens einer LED besteht.

11. Halbleiterlichtmodul nach einem der vorhergehenden Ansprüche, **dadurch gekennzeichnet, dass** die Halbleiterlichtquelle aus mindestens einer OLED besteht.

12. Halbleiterlichtmodul nach einem der vorhergehenden Ansprüche, **dadurch gekennzeichnet, dass** die Platine eine weitere Leiterbahnebene aufweist, und dass diese Ebene eine Masseebene ist und elektrisch mit der Moduloberfläche verbunden ist.

13. Halbleiterlichtmodul nach einem der vorhergehenden Ansprüche, **dadurch gekennzeichnet, dass** der Eingangsfilter (506), der Anbindung an die Fahrzeugmasse/Erde (545) hat, entweder direkt oder über einen Koppelkondensator (C_{Koppel}) an die Masse der Ansteuerschaltung (535) angebunden ist.

14. Halbleiterlichtmodul nach einem der vorhergehenden Ansprüche, **dadurch gekennzeichnet, dass** das Modul aus Aluminium besteht.

## Claims

1. Semiconductor light module comprising integrated drive electronics, wherein the semiconductor light module comprises a heat-conducting, electrically conducting material, on which a circuit board (500) is located, wherein the circuit board (500) comprises at least two conductor track levels, the first level (510) is oriented outward in the light emission direction in the installed state and the second level (515) inward, **characterized in that** at least one semiconductor light source is applied to the disc-shaped semiconductor light module, and the circuit board with the drive electronics is positioned around the semiconductor light source, wherein the second level (515) is enclosed by a closed cavity incorporated into the semiconductor light module, and wherein the ground-carrying lines of the circuit board (500) are electrically connected to the surface of the semiconductor light module.

2. Semiconductor light module according to Claim 1, **characterized in that** the circuits which cause electromagnetic interference are predominantly situated on the second conductor track level.

3. Semiconductor light module according to either of Claims 1 and 2, **characterized in that** the semiconductor light module has an integrally formed heat sink.

4. Semiconductor light module according to Claim 3, **characterized in that** the heat sink is provided with cooling fins.

5. Semiconductor light module according to Claim 3, **characterized in that** the heat sink is provided with separate cooling elements.

6. Semiconductor light module according to Claim 5, **characterized in that** the separate cooling elements have an axially symmetrical form.

7. Semiconductor light module according to Claim 5, **characterized in that** the separate cooling elements have a honeycomb or drop form.

8. Semiconductor light module according to Claim 3, **characterized in that** the heat sink has a tubular structure, and **in that** an air entrance opening is situated at the lower edge of the heat sink, such that an air circulation is promoted by the chimney effect that occurs.

9. Semiconductor light module according to either of Claims 1 and 2, **characterized in that** an external heat sink can be fitted to the semiconductor light module.

10. Semiconductor light module according to any of the preceding claims, **characterized in that** the semiconductor light source comprises at least one LED.

11. Semiconductor light module according to any of the preceding claims, **characterized in that** the semiconductor light source comprises at least one OLED.

12. Semiconductor light module according to any of the preceding claims, **characterized in that** the circuit board has a further conductor track level, and **in that** said level is a ground level and is electrically connected to the module surface.

13. Semiconductor light module according to any of the preceding claims, **characterized in that** the input filter (506), which is linked to the vehicle ground/ground (545), is linked to the ground of the drive circuit either directly or via a coupling capacitor (C_{couple}).

14. Semiconductor light module according to any of the preceding claims, **characterized in that** the module is composed of aluminium.

## Revendications

1. Module d'éclairage à semi-conducteurs avec électronique de commande intégrée, le module d'éclairage à semi-conducteurs étant composé d'une matière conductrice de chaleur et d'électricité sur laquelle se trouve une carte (500), la carte (500) étant composée d'au moins deux niveaux de pistes conductrices, le premier niveau (510) étant, à l'état monté, tourné vers l'extérieur en direction du rayonnement lumineux et le deuxième niveau (515) étant tourné vers l'intérieur, **caractérisé en ce qu'**au moins une source lumineuse à semi-conducteurs est appliquée sur le module d'éclairage à semi-conducteurs en forme de disque et **en ce que** la carte comportant l'électronique de commande est placée autour de la source lumineuse à semi-conducteurs, le deuxième niveau (515) étant entouré d'une cavité fermée aménagée dans le module d'éclairage à semi-conducteurs, et les lignes de masse de la carte (500) étant reliées électriquement à la surface du module d'éclairage à semi-conducteurs.

2. Module à semi-conducteurs selon la revendication 1, **caractérisé en ce que** les circuits produisant des perturbations électromagnétiques se trouvent pour l'essentiel sur le deuxième niveau de pistes conductrices.

3. Module à semi-conducteurs selon l'une des revendications 1 ou 2, **caractérisé en ce que** le module d'éclairage à semi-conducteurs comporte un corps de refroidissement formé dessus d'un seul tenant.

4. Module à semi-conducteurs selon la revendication 3, **caractérisé en ce que** le corps de refroidissement est pourvu de nervures de refroidissement.

5. Module à semi-conducteurs selon la revendication 3, **caractérisé en ce que** le corps de refroidissement est pourvu d'éléments de refroidissement isolés.

6. Module à semi-conducteurs selon la revendication 5, **caractérisé en ce que** les éléments de refroidissement isolés présentent une forme axisymétrique.

7. Module à semi-conducteurs selon la revendication 5, **caractérisé en ce que** les éléments de refroidissement isolés présentent une forme de nid d'abeille ou de goutte.

8. Module à semi-conducteurs selon la revendication 3, **caractérisé en ce que** le corps de refroidissement présente une structure tubulaire et **en ce qu'**un orifice d'admission d'air se trouve au bord inférieur du corps de refroidissement, de sorte qu'une circulation d'air est favorisée par l'effet de cheminée qui se produit.

9. Module à semi-conducteurs selon l'une des revendications 1 ou 2, **caractérisé en ce qu'**un corps de refroidissement externe peut être monté sur le module d'éclairage à semi-conducteurs.

10. Module à semi-conducteurs selon l'une des revendications précédentes, **caractérisé en ce que** la source lumineuse à semi-conducteurs se compose d'au moins une LED.

11. Module à semi-conducteurs selon l'une des revendications précédentes, **caractérisé en ce que** la source lumineuse à semi-conducteurs se compose d'au moins une OLED.

12. Module à semi-conducteurs selon l'une des revendications précédentes, **caractérisé en ce que** la carte comporte un autre niveau de pistes conductrices et **en ce que** ce niveau est un niveau de masse et est relié électriquement à la surface du module.

13. Module à semi-conducteurs selon l'une des revendications précédentes, **caractérisé en ce que** le filtre d'entrée (506), qui est relié à la masse/terre du véhicule (545), est relié soit directement, soit via un condensateur de couplage (C_{Koppel}) à la masse du circuit de commande (535).

14. Module à semi-conducteurs selon l'une des revendications précédentes, **caractérisé en ce que** le module se compose d'aluminium.
